# EUROPÄISCHE PATENTANMELDUNG

(11) **EP 4 201 204 A1**
(43) Veröffentlichungstag der Anmeldung: **28.06.2023**
(21) Anmeldenummer: 21216404.0
(22) Anmeldetag: 21.12.2021
(51) Int. Cl.: A01N 59/00, A01N 59/16, A01N 59/20, A01N 25/34, C02F 1/46, C02F 1/72, D06M 11/83

(54) **ANTIBAKTERIELL AUSGERÜSTETES OBJEKT UND VERFAHREN ZU DESSEN HERSTELLUNG**

(71) Anmelder: Atomos Master Key GmbH, 8807 Freienbach (CH)
(72) Erfinder: HÜTHER, Fabio, 8272 Ermatingen (CH)
(74) Vertreter: Gachnang AG Patentanwälte

(57) **Zusammenfassung**

Objekte, die ein elektrisch nichtleitendes Substrat umfassen, werden antibakteriell ausgerüstet, indem das Substrat durch Sputtern von Partikeln aus Titan und mindestens einem weiteren Metall so beschichtet werden, dass die beschichteten Partikel in unterschiedlichen Kombinationen als Cluster auf dem Substrat angeordnet sind, wobei die Partikel innerhalb der Cluster elektrisch leitend miteinander verbunden sind, und wobei die Cluster inselartig beabstandet zueinander und elektrisch isoliert voneinander auf dem Substrat angeordnet sind.

## Beschreibung

Die Erfindung betrifft ein antibakteriell ausgerüstetes Objekt und ein Verfahren zum Herstellen eines antibakteriell ausgerüsteten Objekts gemäss dem Oberbegriff der Patentansprüche 1 und 10.

Krankheitserregende Keime wie Bakterien oder Viren gefährden in zunehmendem Mass die Gesundheit von Menschen und Tieren. Die Übertragung kann insbesondere über kontaminiertes Wasser, Aerosole, Tröpfchen oder durch direkten Kontakt erfolgen. Durch geeignete Hygienemassnahmen können Keime abgetötet oder an der Weiterverbreitung gehindert werden.

Bei der Aufbereitung von Trinkwasser können unterschiedliche Techniken eingesetzt werden wie z.B. Filtration zum Entfernen von Partikeln, Umkehrosmose zum Entfernen von Salzen und Zugabe von Ozon oder Chlor oder Bestrahlung mit UV-Licht zur Desinfektion bzw. zur Verminderung von infektiösen Keimen. Die chemische Kontaminierung durch Chlor darf nur innerhalb zugelassener Grenzwerte erfolgen. Chloriertes Wasser ist zudem geruchlich und geschmacklich nicht neutral.

Es ist auch bekannt, Wasser elektrochemisch zu behandeln. Dabei werden Elektroden im Wasser mit einem Gleich- oder Wechselspannungssignal beaufschlagt. Durch solche Elektrolyseverfahren können z.B. unerwünschte Ionen wie Schwermetallionen aus dem Wasser entfernt werden. In analoger Weise können dem Wasser auch erwünschte Partikel aus dem Material der Elektroden zugeführt werden. Insbesondere können dem Wasser mittels Elektrolyse geladene und elektrisch neutrale Nanopartikel, z.B. Silber- und/oder Kupferpartikel, zugeführt werden. Flüssige Dispersionen mit solchen Partikeln werden auch als Kolloide bezeichnet. Silberionen wirken desinfizierend. Sie können Viren, Bakterien und andere Keime abtöten. Kupferionen wirken gegen im Wasser enthaltene Pilze und/oder Algen.

Es ist auch bekannt, dass reaktive Sauerstoffspezies (ROS) bzw. kurz Sauerstoffradikale eine schädigende Wirkung auf Bakterien und Viren haben. Freie Radikale sind kurzlebige Molekülfragmente wie z.B. das Hydroxyl-Radikal OH. Als Radikal besitzt es ein einzelnes, ungepaartes Elektron und ist somit sehr reaktiv. Solche freien Radikale verursachen eine Protein Denaturierung, brechen DNA/RNA-Ketten, und zerstören Lipidumhüllungen. Einige Aminosäuren in Proteinen wie z.B. aromatische Ringe und thiolhaltige Aminosäuren, sind sehr anfällig für freie Radikale und reaktive Sauerstoffspezies. Aminosäuren mit aromatischen Ringgruppen wie Phenylalanin, Tyrosin, Tryptophan und Histidin sowie Aminosäuren mit Schwefelgruppen wie Methylaminosäure, Cystin- und Bicystin-Aminosäuren basieren auf einem Kohlenstoff mit vier funktionellen Gruppen: Aminogruppe - NH2, Carboxylgruppe -COOH, H und R-Gruppen mit verschiedenen Formen.

Aus der DE10009643A1 ist eine Vorrichtung zum Behandeln von verunreinigtem Wasser bekannt, wobei das Wasser eine Kammer durchströmt. In dieser Kammer sind vier Elektroden angeordnet und mit wasserdicht aus der Kammer herausgeführten elektrischen Anschlüssen verbunden. Mindestens eine der Elektroden enthält Silber und/oder Kupfer oder eine Legierung aus diesen Metallen. Die Elektroden werden mit einer Gleich- oder Wechselspannung beaufschlagt, wobei die Polarität jeweils so gewechselt wird, dass jede Elektrode im zeitlichen Mittel gleich lang als Kathode und als Anode verwendet wird. Aufgrund der über die Anschlüsse von aussen zugeführten elektrischen Spannung geben die Elektroden Silber- und/oder Kupferionen an das Wasser ab. Ionisierte Nanopartikel im Wasser sind vergleichsweise reaktiv und verbinden sich leicht mit schädlichen Molekülen im Wasser. Aufgrund ihrer Reaktivität können solche ionisierte Partikel aber auch eine Gefahr für die Umwelt und Lebewesen darstellen. Bei der elektrochemischen Abgabe von Partikeln an Wasser sollte deshalb der Anteil ionisierter Partikel beschränkt werden.

Das Abtöten und/oder Verhindern der Ausbreitung von Keimen ist nicht nur bei der Aufbereitung von Wasser von grosser Wichtigkeit. Auch in vielen anderen Bereichen sind geeignete Massnahmen zur Verbesserung der Hygiene erforderlich, insbesondere in Spitälern, bei Gastrobetrieben und in der Lebensmittelindustrie. Dabei ist es oft nicht möglich, wie bei der Wasseraufbereitung zum Abtöten von Keimen ein Gerät zu installieren. Bei diversen Anwendungen ist auch die Notwendigkeit einer externen Energieversorgung problematisch.

Gewisse Bakterien können auch deshalb unerwünscht sein, weil sie Effekte verursachen, die für den Menschen unangenehm sind. Dazu gehört z.B. Schweissgeruch, der beim Zersetzen von im Schweiss enthaltenen Fettsäuren durch Bakterien entsteht.

Eine Aufgabe der vorliegenden Erfindung ist es, ein Objekt bzw. eine Vorrichtung zu schaffen, die ohne Zufuhr von elektrischer Energie eine antibakterielle Wirkung haben, und ein Verfahren zu deren Herstellung anzugeben. Im Zusammenhang mit der vorliegenden Erfindung ist der Ausdruck "antibakterielle Wirkung" im Sinne einer hemmenden oder zerstörenden Wirkung auf Vertreter aus mindestens einer der folgenden Kategorien zu verstehen: Keime, insbesondere anaerobe mesophile Keime, pathogene Keime, Bakterien, Viren, Pilze, Algen.

Diese Aufgabe wird gelöst durch ein antibakteriell ausgerüstetes Objekt und durch ein Verfahren zu dessen Herstellung gemäss den Merkmalen der Patentansprüche 1 und 10.

Bei elektrisch gut leitenden Metallen wie Silber und Kupfer ist die Beweglichkeit von Valenzelektronen vergleichsweise gross. Vereinfachend wird dies auch als Elektronenmeer bezeichnet. Dies begünstigt die Bildung von freien Radikalen.

Überraschenderweise können Keime durch unterschiedliche Legierungen mit unterschiedlichen Redoxpotentialen ohne externe Energiezufuhr unschädlich gemacht werden. Dies gilt auch bei mikroskopisch kleinen Partikeln einer Legierung bzw. bei Verbindungen, die mindestens zwei Komponenten umfassen, wovon mindestens eine ein Metall ist. Im vorliegenden Dokument umfasst der Begriff "Legierung" auch mikroskopisch kleine und nanoskalige Partikel solcher Verbindungen.

Die antibakterielle Wirkung ist besonders stark, wenn eine Vielzahl kleiner Legierungspartikel mit unterschiedlichen Zusammensetzungen der jeweiligen Komponenten mit geringen gegenseitigen Abständen zueinander angeordnet sind. Besonders effektiv sind Anordnungen, die einen hohen Anteil an Nanopartikeln umfassen. Nanopartikel umfassen Verbünde von einigen wenigen bis zu einigen tausend Atomen oder Molekülen. Sie haben im Vergleich zu grösseren Agglomeraten ein grosses Oberflächen/Volumen-Verhältnis. Eigenschaften von Nanopartikeln können sich wesentlich von Eigenschaften grösserer Partikel unterscheiden. Insbesondere haben Nanopartikel in der Regel eine grössere chemische Reaktivität. Im Nahbereich von Nanoteilchen ist die abstossende elektrostatische Wechselwirkung deutlich grösser als die anziehende van-der-Waals-Wechselwirkung. Elektronenwolken an der Oberfläche von Nanopartikeln bilden freie Radikale. Diese können Proteine wie Zellmembranen von Bakterien zerstören. Dies gilt auch für Wasserstoffbrückenbindungen zwischen dem S1-Protein und dem S2-Protein von Viren.

Zur wirksamen Bekämpfung von Bakterien und/oder Pilzen sind nanoskalige Partikel aus Legierungen bzw. Verbindungen mit Silber und/oder Kupfer besonders wirksam. Die Partikel können auch Verbindungen mit anderen Metallen wie z.B. Titan, Nickel oder Stahl bzw. Eisen und Kohlenstoff umfassen.

Diverse Objekte können mittels solchen nanoskaligen Partikeln antibakteriell ausgerüstet werden. Dabei werden durch physikalische Gasphasenabscheidung, insbesondere durch Sputtern, mindestens zwei unterschiedliche Metalle auf einem Substrat abgeschieden. Sputtern ist deshalb besonders geeignet, weil sich wichtige Prozessparameter wie die durchschnittliche Grösse der aus dem Target in die Gasphase übergehenden Partikel und Ablagerungsrate auf einem Flächenabschnitt des Substrats gut steuern lassen. Die Abscheidung der einzelnen Metalle kann sequentiell bzw. zeitlich nacheinander oder parallel bzw. näherungsweise gleichzeitig in einer Vakuumkammer erfolgen. Dabei wird das zu beschichtende Material z.B. durch Ionenbeschuss aus entsprechenden Targets gelöst und in die Gasphase überführt. Die Abscheidungsrate auf dem Substrat kann durch ein elektrisches Feld beeinflusst werden. Zusätzlich kann beim Magnetronsputtern durch ein Magnetfeld beim Target eine wesentlich höhere Abtragungsrate bei gleichem Prozessdruck erreicht werden. Magnetronsputtern ist auch deshalb vorteilhaft, weil die Beschichtung eines Substrats mit deutlich niedrigerem Prozessdruck möglich ist, was eine sehr effiziente und effektive Beschichtung eines Substrats ermöglicht. Dies gilt ganz besonders, wenn das Substrat ein Flächengebilde ist, das einseitig oder beidseitig in einem Rolle-zu-Rolle-Verfahren beschichtet wird. Dabei kann das Flächengebilde wahlweise kontinuierlich oder diskontinuierlich bzw. schrittweise von einer Vorratsrolle auf eine Aufnahmerolle umgespult werden. Targets aus gleichen oder unterschiedlichen Materialien können in beliebigen Kombinationen einseitig oder beidseitig des Flächengebildes und in Bezug auf die Prozessrichtung nacheinander und/oder nebeneinander in der Prozesskammer angeordnet sein. Die Targets können in der Prozesskammer so angeordnet sein, dass das hochenergetische Plasma beim Sputtern gleichzeitig auf alle Targets auftrifft. Alternativ können Mittel vorgesehen sein, die ein sequentielles Beschichten des Substrats mit Material der unterschiedlichen Targets ermöglicht wird. So kann z.B. die Ausrichtung der Plasmaquelle veränderbar sein. Alternativ kann jedes Target individuell durch eine eigene Plasmaquelle beeinflusst werden. Die Targets können auch in verschiedenen Abschnitten einer Hochvakuumkammer angeordnet sein, sodass die Beschichtung in den einzelnen Abschnitten separat gesteuert werden kann. Alternativ kann die Beschichtungsanlage mehrere unabhängige Hochvakuumkammern zum sequentiellen Sputtern verschiedener Materialien umfassen.

Durch die Art und Anordnung der Targets in der Prozesskammer kann das Ergebnis des Beschichtungsprozesses auf dem Substrat beeinflusst werden. Dies gilt insbesondere im Hinblick auf die Menge und Reihenfolge von Partikeln, die aus unterschiedlichen Targets gelöst und auf dem Substrat abgeschieden werden. So kann z.B. zuerst ein Bindemittel abgeschieden werden, das gut auf dem Substrat haftet und das gute Bindungseigenschaften für weitere abzuscheidende Materialien aufweist. Ein bevorzugtes Bindemittel ist insbesondere Titan. Titan haftet z.B. hervorragend auf Vliesen und textilen Flächengebilden und hat aufgrund seiner Struktur mehrere Andockstellen für weitere Materialien, insbesondere für Metalle wie z.B. Kupfer (Cu), Silber (Ag), Gold (Au), Nickel (Ni) oder Eisen (Fe).

Jedes der Metalle kann einmal oder mehrmals abgeschieden werden. Dabei bilden sich auf dem Substrat eine Vielzahl von Clustern bzw. nanoskaligen Partikeln, die inselartig verteilt angeordnet sind, und die sich durch die Anzahl und Art der zusammenhängenden Atome bzw. Moleküle unterscheiden können.

Durch Vorgabe oder Einstellung gewisser Prozessparameter kann das Ergebnis der Beschichtung auf dem Substrat entsprechend der jeweiligen Anforderungen definiert werden. Solche Prozessparameter können z.B. die Konfiguration der Prozesskammer an sich und/oder die Steuerung des Beschichtungsprozesses betreffen.

Beispiele solcher Prozessparameter sind Anzahl, Grösse und Anordnung von Targets in der Prozesskammer sowie deren Materialien; Prozessdruck in der Prozesskammer; Mittlere Energie bzw. Geschwindigkeit der von der Ionen-Strahlungsquelle abgegebenen Teilchen; Abstand der Targets vom Substrat in der Prozesskammer; Art und Stärke von elektrischen und/oder magnetischen Feldern in der Prozesskammer, welche die Abscheidungsrate beim Beschichten des Substrats beeinflussen; Dauer von Beschichtungsintervallen; Geschwindigkeit von Substratabschnitten relativ zu den jeweiligen Targets während der Beschichtung; Reihenfolge der Beschichtung mit Material von unterschiedlichen Targets.

Zum definierten Abscheiden eines oder mehrerer Metalle können ein oder mehrere solcher Prozessparameter der Beschichtungsanlage entsprechend der jeweiligen Anforderungen an das beschichtete Substrat vorgegeben bzw. eingestellt werden.

Insbesondere kann z.B. bei nacheinander ausgeführten Beschichtungsschritten mit unterschiedlichen Metallen die Beschichtungsdauer für jedes der Beschichtungsintervalle individuell vorgegeben werden. Die entsprechenden Zeiten können so vorgegeben werden, dass pro Flächeneinheit des Substrats eine hohe Anzahl Partikelinseln ausgebildet werden, die elektrisch isoliert in geringen Abständen relativ zueinander angeordnet sind. Die Zusammensetzungen dieser Partikelinseln bzw. die Anzahl und Art der abgeschiedenen und jeweils innerhalb einer Partikelinsel miteinander verbundenen Atome oder Moleküle sind nicht einheitlich. Sie sind bei jeder Partikelinsel individuell und können zum Teil grosse Unterschiede aufweisen. Ausgehend von einem unbeschichteten Substrat nimmt der Anteil der auf dem Substrat abgeschiedenen Partikel mit zunehmender Dauer der Beschichtungsintervalle zu. Dabei können die Anteile der abgeschiedenen unterschiedlichen Materialien z.B. dadurch gesteuert werden, dass die Dauer der Beschichtungsintervalle für jedes dieser Materialien individuell vorgegeben wird.

Die Abscheidung von Partikeln kann direkt an freien Stellen der Substratoberfläche oder durch Anlagerung an bereits abgeschiedenen Partikeln erfolgen. Mit zunehmender Beschichtungsdauer erhöht sich der Anteil von Partikeln, die sich mit bereits abgelagerten Partikeln auf dem Substrat verbinden. Es bilden sich Partikelinseln, deren Anzahl und Grösse in einer ersten Phase mit zunehmender Abscheidungsdauer zunimmt. Damit einhergehend nimmt der mittlere Abstand zwischen benachbarten Partikelinseln ab. Benachbarte Partikelinseln, deren Abstand sehr klein ist, können durch weitere Abscheidung von Partikeln zu einer einzigen Partikelinsel zusammenwachsen. Nach einer anfänglichen Zunahme nimmt die Rate der pro Zeiteinheit neu gebildeten Partikelinseln in einer zweiten Phase mit zunehmender Beschichtungsdauer ab. Dabei erhöht sich der Anteil der Partikel, die an bereits vorhandenen Partikelinseln abgeschieden werden, und benachbarte Partikelinseln wachsen vermehrt zusammen.

Bei einer ausreichend langen Beschichtungsdauer würden sich näherungsweise alle Partikelinseln zu einer zusammenhängenden Schicht auf der Substratoberfläche verbinden.

Die antibakterielle Wirkung eines beschichteten Substrats ist besonders effektiv, wenn die durchschnittliche Anzahl Partikelinseln pro Flächeneinheit des Substrats eher gross oder maximal ist. Der mittlere Abstand zwischen benachbarten Partikelinseln ist dann vergleichsweise klein. Bei vielen Anwendungen genügt jedoch bereits eine deutlich kleinere Anzahl Partikelinseln pro Flächeneinheit, um dem Substrat eine ausreichend gute antibakterielle Wirkung zu verleihen. Dies kann z.B. durch entsprechend kurze Beschichtungsintervalle erreicht werden. Da die Beschichtung eines Substrats in einer Vakuumkammer aufwändig und teuer ist, können Substrate auf diese Weise relativ kostengünstig und dennoch wirksam antibakteriell ausgerüstet werden.

Bei einer sequentiellen Beschichtung des Substrats mit Material von mehreren Targets kann z.B. die Dauer der einzelnen Beschichtungsintervalle so vorgegeben werden, dass die gesamte Beschichtungsdauer zwischen etwa 10% und etwa 90% der gesamten Beschichtungsdauer der ersten Phase beträgt, während der die mittlere Anzahl und Grösse von Partikelinseln auf der Substratoberfläche zunimmt. Das Massenverhältnis oder das Verhältnis der Anzahl Teilchen der unterschiedlichen, auf einer Flächeneinheit des Substrats abgeschiedenen Materialien können z.B. durch entsprechende Verhältnisse der Dauer der zugehörigen Beschichtungsintervalle gesteuert werden.

Eine geeignete Dauer der Beschichtungsintervalle kann z.B. für jedes der zu beschichtenden Materialien experimentell ermittelt werden. Insbesondere kann für jedes Material der pro Zeiteinheit auf einer Flächeneinheit des Substrats abgeschiedene Masseanteil ermittelt werden. Durch Testen der antibakteriellen Wirkung oder anderer Eigenschaften bei unterschiedlich beschichteten Substraten können optimale Materialzusammensetzungen der Beschichtung und die entsprechenden Prozessparameter, insbesondere die Dauer der einzelnen Beschichtungsintervalle ermittelt werden. Dabei können die Prozessparameter z.B. so festgelegt werden, dass die antibakterielle Wirkung des beschichteten Substrats bei vorgegebenen Messbedingungen maximal ist. Alternativ können die Prozessparameter in analoger Weise so optimiert werden, dass die antibakterielle Wirkung für eine bestimmte Anwendung ausreichend ist. Die Beschichtungsintervalle und die Herstelldauer sind entsprechend kürzer, der Materialverbrauch geringer und die Herstellkosten tiefer. Besonders effizient sind Prozesse, bei denen das Substrat ein bandartiges Flächengebilde ist, das innerhalb der Prozesskammer von Rolle zu Rolle gefördert wird. Die Breite solcher Substratbänder ist vorzugsweise grösser als 1m und liegt beispielsweise zwischen 1.5m und 2m. Die Abmessungen der Prozesskammer, in der Substratbänder beschichtet werden sollen, beschränkt die maximal mögliche Breite der Substratbänder.

Vorzugsweise wird das Substrat vorgängig zum Abscheiden von Metallen gereinigt. Dies kann z.B. durch Plasma einer Ionenplasmaquelle erfolgen. Diese kann in der gleichen Prozesskammer angeordnet sein, in der auch die Beschichtung mit den Metallen erfolgt.

Vorzugsweise wird in einem ersten Beschichtungsschritt Titan von einem Titantarget auf dem Substrat abgeschieden. Titan hat aufgrund seiner Struktur die Eigenschaft, dass es sich gut mit dem Substrat verbinden kann und mehrere Andockstellen zum Anbinden weiterer Partikel wie Atome oder Moleküle umfasst. Beim Abscheiden von einem oder mehreren Metallen in einem oder mehreren weiteren Beschichtungsschritten sind die Titanpartikel bevorzugte Keimzellen für die Ausbildung von unterschiedlichen Partikelinseln. Beim Abscheiden weiterer Metallpartikel verbinden sich diese bevorzugt mit Titanpartikeln auf dem Substrat. Ein Teil der weiteren Metallpartikel wird direkt auf der Substratoberfläche abgeschieden.

Die Dauer der einzelnen Beschichtungsintervalle wird ausreichend kurz gewählt, sodass an der Oberfläche des Substrats keine durchgehende elektrisch leitende Schicht entsteht. Das Substrat selbst ist in der Regel elektrisch nichtleitend. Bei Bedarf kann ein elektrisch leitendes Substrat mit einer elektrisch isolierenden Schicht ausgerüstet werden, bevor Metalle darauf abgeschieden werden. Die durchschnittliche Grösse der Partikelinseln ist vorzugsweise kleiner als 100nm. Sie kann z.B. im Bereich von etwa 1nm bis etwa 100nm liegen, insbesondere zwischen 10nm und 50nm. Die Grösse einer Partikelinsel ist definiert durch deren Maximalausdehnung bzw. deren grösste Dicke.

Der durchschnittliche gegenseitige Abstand von benachbarten Partikelinseln kann z.B. in einer ähnlichen Grössenordnung liegen oder grösser sein. Er ist jedoch vorzugsweise kleiner als 10000nm.

Die Ausbildung von unterschiedlichen Partikelinseln bzw. Clustern kann dadurch begünstigt werden, dass mindestens eines der Metalle in einer Abfolge mehr als einmal gesputtert wird. Eine besonders gute antibakterielle Wirkung kann bei einem Substrat dadurch erreicht werden, dass folgende Materialien in der angegebenen Reihenfolge auf dem Substrat abgeschieden werden: Titan - Kupfer - Silber - Kupfer - Silber.

Das Substrat ist vorzugsweise ein textiles oder nicht textiles Flächengebilde, beispielsweise ein Vliesstoff oder ein Gewebe. Bei Flächengebilden mit strukturierten Oberflächen aus Fasern ist die nutzbare Oberfläche zum Abscheiden von Partikeln grösser als bei glatten Oberflächen. Zudem begünstigt die dreidimensionale Oberflächenstruktur die Ausbildung von elektrisch nicht miteinander verbundenen Partikelinseln. Im Weiteren verbessert die Oberflächenstruktur die Haftung abgeschiedener Partikel. Ein weiterer Vorteil besteht darin, dass solche Flächengebilde zwischen den Fasern offene Poren bzw. durchgehende Öffnungen haben und als Filter für fluide Medien nutzbar sind.

Das Material des Substrats kann z.B. einen Kunststoff, insbesondere ein Polyamid wie Nylon, Polypropylen (PP), Polyethylen (PE), Polyethylenterephtalat (PET) oder Polymethylmethacrylat (PMMA bzw. Acrylglas) umfassen.

Das Substrat kann z.B. ein hydrophobes Vlies oder Gewebe aus PET mit einer linearen Faser- bzw. Garndichte von etwa 0.15 denier sein. 1 denier entspricht etwa 1.1 x 10-4 Gramm pro Meter. In einer weiteren Ausführungsform kann das Substrat z.B. ein hydrophiles Vlies oder Gewebe aus PP mit einer linearen Dichte von etwa 9 denier sein. Besonders geeignet sind Kompositmaterialien mit zwei oder mehreren Polymeren, beispielsweise Mikrofilament-Vliesstoffe, wie sie unter der Marke Evolon^{®} von der Firma Carl Freudenberg KG in Deutschland bekannt sind.

Bei weiteren Ausführungsformen kann das Material des Substrats z.B. auch keramische Werkstoffe umfassen.

Bei Substraten in Gestalt von flexiblen Flächengebilden werden die Beschichtungsmaterialien vorzugsweise in einem Rolle-zu-Rolle-Verfahren auf eine oder beide Oberflächen des Substrats gesputtert. Dies ermöglicht eine effiziente und kostengünstige Beschichtung des Substrats. Vorzugsweise werden z.B. durch Magnetronsputtern mehrere Beschichtungsmaterialien, insbesondere Titan, Kupfer und Silber, in einer Hochvakuumkammer auf das Substrat aufgebracht. Dabei werden durch energiereiches Plasma bzw. Ionen Nanoteilchen aus Targets mit den jeweiligen Beschichtungsmaterialien herausgelöst, die sich dann aus der Gasphase auf dem Substrat niederschlagen. Dabei können aus mehreren unterschiedlichen Targets gleichzeitig oder alternativ nacheinander entsprechende Nanoteilchen herausgelöst werden. Vorzugsweise erfolgt die Beschichtung mit den verschiedenen Targetmaterialien sequentiell nacheinander. Da Titan gut an den meisten Substraten haftet, erfolgt in der Regel zuerst eine Beschichtung des Substrats mit Titan. Die anderen Beschichtungsmaterialien werden anschliessend vorzugsweise ebenfalls nacheinander gesputtert.

Die Targets können z.B. in Prozessrichtung nacheinander oder nebeneinander in der Beschichtungskammer angeordnet sein. Die Vorrichtung zum Erzeugen des Plasmas bzw. allgemein der energiereichen Teilchen kann z.B. dazu ausgebildet sein, aus allen Targets gleichzeitig Nanoteilchen für die Abscheidung auf dem Substrat herauszulösen. Alternativ kann die Vorrichtung dazu ausgebildet sein, die einzelnen Targets z.B. mit einer oder mehreren Plasmaquellen sequentiell nacheinander zu beschiessen. Dies hat den Vorteil, dass die Abscheidung unterschiedlicher Nanoteilchen auf dem Substrat besser kontrolliert werden kann. Insbesondere können auf diese Weise Parameter wie Reihenfolge und Beschichtungsdauer bzw. Menge der einzelnen auf das Substrat aufzubringenden Materialien vorgegeben und kontrolliert werden. Vorzugsweise wird zuerst Titan auf dem Substrat abgeschieden. Titan weist einen hohen Grad an kovalenter Bindung auf und eignet sich aufgrund seiner oktaedrischen Koordinationsgeometrie hervorragend als Bindemittel. Titan haftet gut an Polymersubstraten und ermöglicht eine starke Anbindung von Nanoteilchen der weiteren Targets, insbesondere Kupfer und Silber.

Je nach Verwendungszweck kann das beschichtete Substrat selbst als antibakteriell ausgerüstetes Objekt bzw. antibakteriell ausgerüstete Vorrichtung genutzt werden. So können z.B. in der genannten Art beschichtete Vliese oder Textilien als Reinigungstücher mit einer antibakteriellen Wirkung oder im medizinischen Bereich als antiseptische Unterlagen oder Verpackungen genutzt werden. Anstelle von flexiblen Flächengebilden können auch Oberflächenbereiche von dreidimensionalen und/oder starren Gegenständen durch Abscheidung von Metallen in der genannten Art antibakteriell ausgerüstet werden. Beispiele hierfür sind Türgriffe, Handläufe von Treppengeländern, Bedientasten von Geräten, Arbeitsflächen usw.

Antibakteriell ausgerüstete Substrate können auch als Bestandteile von entsprechenden Vorrichtungen bzw. Objekten ausgebildet sein. Beispiele solcher Objekte sind Wasserfilter, Luftfilter, Schutzmasken, Wundverbände, Kleidungsstücke, Schuheinlagen usw., wobei mindestens eine Lage des Substrats als Oberflächenabschnitt des Objekts ausgebildet oder in das Objekt eingebettet ist.

Anhand einiger Figuren wird die Erfindung im Folgenden näher beschrieben. Dabei zeigen
- Figur 1: eine schematische Darstellung der Beschichtung eines Substrats in einer Sputteranlage,
- Figur 2: eine schematische Darstellung der Oberfläche eines mit unterschiedlichen Materialien beschichteten Flächengebildes,
- Figur 3: eine Filterkartusche,
- Figur 4: eine Atemschutzmaske,
- Figur 5: ein Kleidungsstück.

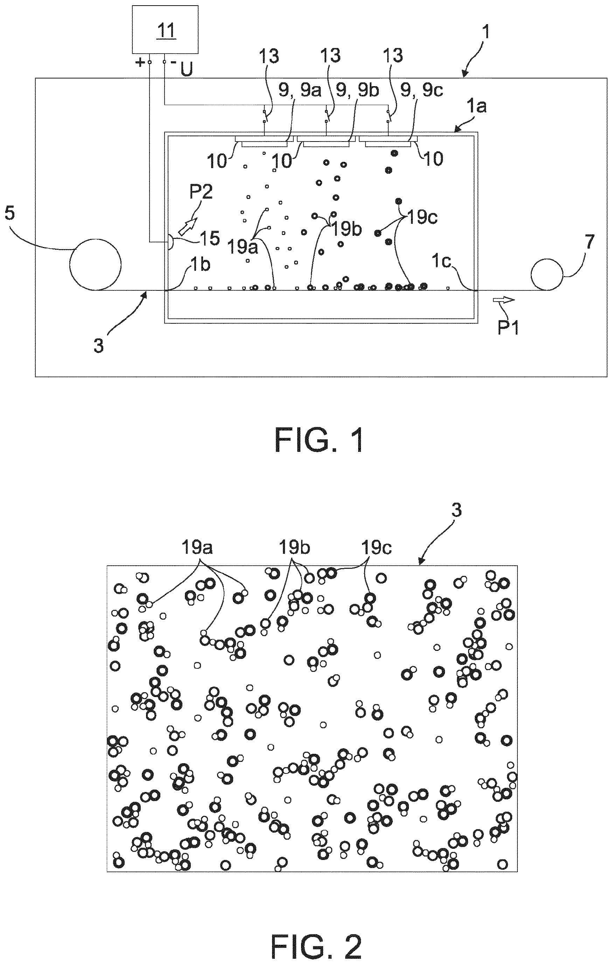

Figur 1 zeigt schematisch eine evakuierbare Kammer 1 einer Sputteranlage, in der ein zu beschichtendes Substrat in Gestalt eines bandartigen Flächengebildes 3 von einer Vorratsrolle 5 auf eine Aufnahmerolle 7 umspulbar angeordnet ist. Die Kammer 1 umfasst einen als Prozesskammer bezeichneten Bereich, in dem das Flächengebilde 3 beschichtet wird. Die Prozesskammer ist vorzugsweise durch eine Wandung 1a gegen angrenzende Bereiche der Kammer 1 abgeschirmt. Durch zwei Durchtrittsöffnungen 1b, 1c der Wandung 1a kann das Flächengebilde 3 beim Umspulen von der Vorratsrolle 5 auf die Aufnahmerolle 7 in einer durch einen Pfeil P1 dargestellten Transportrichtung durch die Prozesskammer hindurchgeführt werden. Innerhalb der Prozesskammer sind mehrere Targets 9 aus unterschiedlichen auf dem Flächengebilde 3 abzuscheidenden Materialien angeordnet, beispielsweise ein erstes Target 9a aus Titan (Ti), ein zweites Target 9b aus Kupfer (Cu) und ein drittes Target aus Silber (Ag). Die Targets 9 können z.B. wie in Figur 1 dargestellt je an einem elektrisch leitenden Träger 10 gegenüberliegend zu einer durch die Durchtrittsöffnungen 1b, 1c definierten Ebene an einem Abschnitt der Wandung 1a der Prozesskammer angeordnet sein. Mit solchen Einrichtungen können Flächengebilde 3 einseitig beschichtet werden. Alternativ können Targets 9 auch beidseitig eines zu beschichtenden Flächengebildes 3 an der Wandung 1a der Prozesskammer angeordnet sein (nicht dargestellt). Die Sputteranlage umfasst eine Steuerung 11 mit einer Spannungsquelle, die eine Gleichspannung oder allgemein eine Spannungsfunktion, z.B. eine gepulste Spannung mit vorgegebener Polarität bereitstellt. Vorzugsweise ist jedes Target 9a, 9b, 9c über ein individuelles Schaltelement 13 als Kathode mit dem negativen Pol dieser Spannungsquelle verbindbar. Der positive Pol der Spannungsquelle ist mit einer oder mehreren Anoden 15 verbunden, die zum Beschleunigen von Ionen einer Plasmaquelle (nicht dargestellt) in Richtung eines oder mehrerer der Targets 9 verwendet wird. Dies ist in Figur 1 symbolisch durch den Pfeil P2 dargestellt. Vorzugsweise wird das Plasma aus in die Prozesskammer eingeleitetem Argongas erzeugt. Die Targets 9a, 9b, 9c können einzeln oder in beliebigen Kombinationen über die Schaltelemente 13 mit dem Minuspol der Spannungsquelle 11 verbunden werden. Durch das elektrische Feld zwischen der Anode 15 und der bzw. den verbundenen Kathoden werden die positiv geladenen Argonionen in Richtung der jeweiligen Targets 9a, 9b, 9c beschleunigt, wo sie beim Auftreffen Atome oder mehr als ein Atom umfassende Partikel des jeweiligen Targetmaterials herausschlagen. Diese erhalten einen Impuls in Richtung des gegenüberliegenden Abschnitts des Flächengebildes 3, wo sie als Niederschlag haften bleiben.

Figur 2 zeigt schematisch einen vergrösserten Abschnitt der Oberfläche des Substrats bzw. des Flächengebildes 3 während oder nach dem Beschichten mit Partikeln 19a, 19b, 19c der unterschiedlichen Targets 9a, 9b, 9c in Figur 1. Die Partikel 19a, 19b, 19c sind in einer Vielzahl unterschiedlicher Kombinationen als Cluster oder Inseln auf der Substratoberfläche angeordnet. In der Regel werden zuerst Titanpartikel 19a gesputtert. Diese wirken als Keimzellen von Partikelinseln. In einem oder mehreren nachfolgenden Prozessschritten werden z.B. Silber und/oder

Kupfer als weitere Partikel 19b, 19c gesputtert. Diese verbinden sich bevorzugt mit bereits auf dem Substrat abgeschiedenen anderen Partikeln, insbesondere mit Titanpartikeln 19a.

Bei Flächengebilden 3, die mit Titan (Ti), Silber (Ag) und Kupfer (Cu) beschichtet werden, liegen die Verhältnisse der Materialanteile vorzugsweise in folgenden Bereichen:
(Ti:Cu) = (1:4) bis (1:12), beispielsweise etwa (1:8),
(Cu:Ag) = (1:2) bis (1:6), beispielsweise etwa (1:4).

Diese Angaben beziehen sich auf die Anzahl Partikel bzw. Atome der unterschiedlichen auf dem Flächengebilde 3 abgeschiedenen Materialien. Sofern nichts anderes angegeben ist, gelten jeweils Toleranzen von +/- 15%.

Unter Berücksichtigung der atomaren Massen von Titan (ca. 47,8u), Kupfer (ca. 63.5u) und Silber (ca. 107.8u) könnten die Verhältnisse der Materialanteile auch durch die jeweiligen Massenanteile angegeben werden. Diese können z.B. durch Gewichtsmessungen vor und nach dem Sputtern vergleichsweise einfach und genau ermittelt werden.

Die pro m2 Oberfläche des Flächengebildes 3 abgeschiedene Masse der Silberpartikel liegt vorzugsweise in der Grössenordnung von etwa 50mg bis etwa 100mg und beträgt beispielsweise etwa 75mg. Das Flächengebilde 3 kann einseitig oder alternativ beidseitig beschichtet werden. Durch sequentielles Sputtern einer Abfolge von Titan - Kupfer - Silber - Kupfer - Silber können Substrate besonders wirksam antibakteriell ausgerüstet werden.

In weiteren Ausführungsformen kann das Flächengebilde 3 z.B. mit Titan, Silber, Kupfer und Gold (Au) beschichtet werden. Die Materialanteile liegen dabei vorzugsweise in folgenden Bereichen:
(Ti:Cu) = (1:1) bis (1:4), beispielsweise etwa (1:2),
(Cu:Ag) = (1:2) bis (1:4), beispielsweise etwa (1:3),
(Cu:Au) = (2:1) bis (8:1), beispielsweise etwa (5:1).

Bei weiteren alternativen Ausführungsformen können in analoger Weise Titan als Bindemittel und mindestens ein weiteres Metall aus der Gruppe Silber (Ag), Kupfer (Cu), Gold (Au), Nickel (Ni) und Eisen (Fe) auf einem Flächengebilde 3 bzw. allgemein auf einem Substrat abgeschieden werden. Die Anteile der einzelnen Materialien sind in der Regel unterschiedlich. Vorzugsweise werden zusätzlich zu Titan mindestens zwei weitere Metalle gesputtert.

Das Substrat ist vorzugsweise ein textiles oder nicht textiles Flächengebilde 3, insbesondere ein Vlies oder ein Gewebe, das z.B. aus einem Polymer gefertigt ist und eine poröse Faserstruktur aufweist. Solche Flächengebilde 3 können in unterschiedlichen Materialstärken und mit unterschiedlichen Porengrössen bereitgestellt werden und eignen sich als Filterelemente für Fluide wie Wasser und Luft. Im Vergleich zu herkömmlichen Filterelementen haben erfindungsgemässe Filterelemente, die ein mit mindestens zwei unterschiedlichen Metallen beschichtetes Flächengebilde 3 umfassen, zusätzlich eine keimtötende Wirkung. Sie sind auch dazu geeignet, Schwermetalle zu binden.

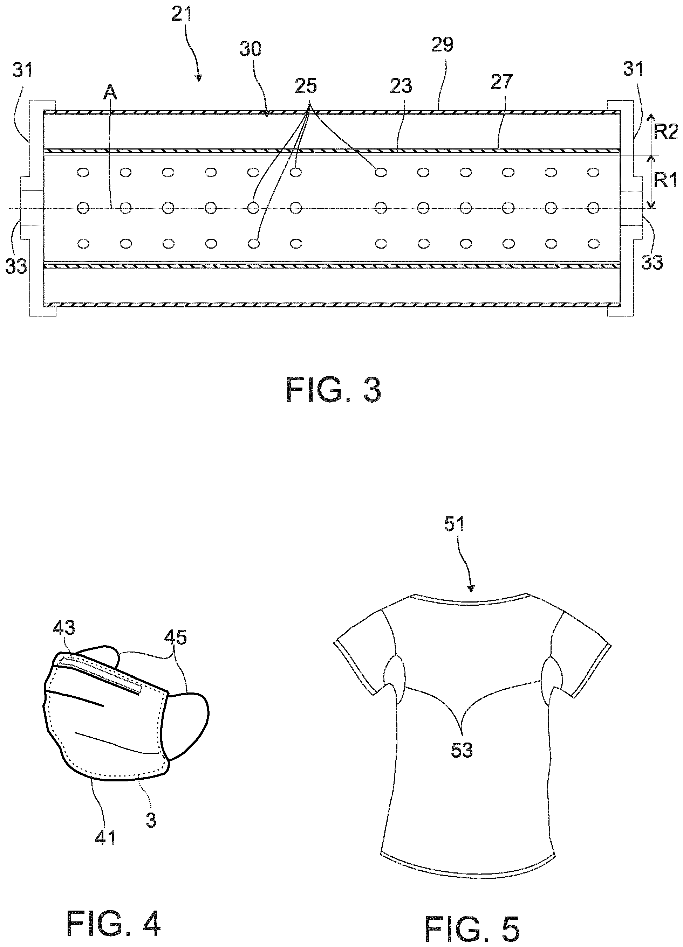

Figur 3 zeigt einen Längsschnitt einer antibakteriell ausgerüsteten Filterkartusche 21. Diese umfasst eine zylindrisches Innenwandung 23, die in einem Abstand bzw. Radius R1 zu einer Zylinderachse A angeordnet ist. Die Innenwandung 23 umfasst Durchtrittsöffnungen 25 und dient als Sammelrohr für eine in der Filterkartusche 21 behandelte Flüssigkeit wie z.B. Wasser. Die Innenwandung 23 ist von einem porösen inneren Filterelement 27 umhüllt, das zusammen mit einem koaxial in einem Abstand bzw. Radius R2 zur Zylinderachse A angeordneten äusseren Filterelement 29 einen Aufnahmeraum 30 begrenzt. Dieser Aufnahmeraum 30 kann mit einer Wirksubstanz entsprechend der Anforderungen der jeweiligen Anwendung der Filterkartusche 21 befüllt werden. Die Wirksubstanz kann z.B. Aktivkohle, Apfelsäure oder ein bioaktives Polymer umfassen. Zumindest das äussere Filterelement 29 umfasst eine oder mehrere Lagen eines erfindungsgemäss mit mindestens zwei unterschiedlichen Metallen beschichteten Vliesstoffs. Die durchschnittliche Porengrösse bzw. der mittlere Durchmesser von durchgehenden Öffnungen zwischen Fasern des Vliesstoffs kann z.B. in der Grössenordnung von 0.8 bis 80 Mikrometer, insbesondere etwa 1 bis etwa 5 Mikrometer liegen. Vorzugsweise gilt dies auch für das innere Filterelement 27. Für Anwendungen im Bereich der Ultrafiltration können Porengrössen auch wesentlich kleiner sein und beispielsweise im Bereich von etwa 10nm bis etwa 30nm liegen. Polysulfone eignen sich wegen ihrer hohen Zähigkeit und Stabilität besonders gut für solche Anwendungen.

Die Anzahl Lagen des aufgewickelten Vliesstoffs beim äusseren Filterelement 29 liegt z.B. zwischen 2 und 50, vorzugsweise zwischen etwa 4 und etwa 20. Sie ist in der Regel grösser oder gleich gross wie beim inneren Filterelement 27. Dadurch können gegebenenfalls vorhandene Schwermetallpartikel effizient aus dem zu filternden Wasser gebunden werden, bevor sie weiter ins Innere der Filterkartusche 21 vordringen können. Die Dicke einer Lage des Vliesstoffs kann z.B. in der Grössenordnung von etwa 0.2 mm bis etwa 1mm liegen, insbesondere im Bereich von etwa 0.5mm bis 0.75mm. Bei solchen Vliesstoffen liegt die spezifische Flächendichte in der Grössenordnung von etwa 40g/m2 bis etwa 400g/m2 und beträgt beispielsweise etwa 50g/m2 oder 170g/m2. Beispiele geeigneter Vliesstoffe sind Mikrofilament

Optional kann das äussere Filterelement 29 analog zum Sammelrohr eine äussere Wandung mit Eintrittsöffnungen für die Flüssigkeit umfassen (nicht dargestellt), wobei eine oder mehrere Lagen des beschichteten Vliesstoffs auf diese äussere Wandung aufgewickelt sind. Diese äussere Wandung erhöht die Stabilität des äusseren Filterelements 29 und damit auch der Filterkartusche 21.

Das äussere Filterelement 29 kann optional von einer Schutzhülle mit Eintrittsöffnungen für die zu behandelnde Flüssigkeit umhüllt sein (nicht dargestellt). Die beiden stirnseitigen Enden der Filterkartusche 21 sind je von einem Deckel 31 verschlossen, wobei mindestens einer dieser Deckel 31 eine zentrale Austrittsöffnung 33 umfasst. Wasser dringt unter Druck radial von aussen her durch das äussere Filterelement 29 in den Aufnahmeraum 30. Dabei werden Keime grösstenteils, vorzugsweise zu mehr als 99% durch das beschichtete Flächengebilde 3 bzw. durch freie Radikale an dessen Oberfläche unschädlich gemacht. Zudem werden Schwermetallpartikel von freien Radikalen am äusseren Filterelement 29 eingefangen und zurückgehalten. Im Aufnahmeraum 30 wird das Wasser der Wirksubstanz ausgesetzt und strömt dann durch das innere Filterelement 27 in das Sammelrohr. Das innere Filterelement 27 bildet dabei eine weitere Reinigungsstufe mit keimtötender Wirkung. Über die Austrittsöffnungen 33 kann das gereinigte Wasser abgeleitet werden.

Figur 4 zeigt ein weiteres Ausführungsbeispiel eines antibakteriell ausgerüsteten Objekts in Gestalt einer Atemschutzmaske. Diese umfasst ein Filterelement 41 mit einer oder mehreren Schichten eines erfindungsgemäss mit mehreren Metallen wie Titan, Silber und Kupfer beschichteten porösen Flächengebildes 3, insbesondere eines Vliesstoffes. Das Flächengebilde 3 bzw. mehrere Lagen des Flächengebildes 3 können z.B. wie in Figur 3 dargestellt zwischen zwei äusseren Lagen des Filterelements 41 eingebettet sein, wobei diese äusseren Lagen eine an die Anatomie des menschlichen Kopfs angepasste oder anpassbare Gestalt haben. Solche Atemschutzmasken umfassen in der Regel zusätzliche Versteifungselemente 43, die z.B. im Bereich des Nasenbeins eine Anpassung an die Konturen individueller Gesichter ermöglichen, sowie elastische Bänder 45 zum Befestigen an den Ohren.

Figur 5 zeigt als weiteres Ausführungsbeispiel eines antibakteriell ausgerüsteten Objekts ein Kleidungsstück, nämlich ein T-Shirt 51. Dieses umfasst in den Achselbereichen Einsätze 53 eines erfindungsgemäss beschichteten Flächengebildes 3. Diese können z.B. als einseitig oder beidseitig beschichtete Gewebe oder Netzstrukturen ausgebildet oder alternativ geschützt zwischen netzartigen Schichten des Kleidungsstücks eingebettet sein.

## Patentansprüche

1. Antibakteriell ausgerüstetes Objekt, umfassend mindestens ein elektrisch nichtleitendes Substrat mit mindestens einem Oberflächenabschnitt, der mit Partikeln von Titan und einem oder mehreren weiteren Metallen beschichtet ist, **dadurch gekennzeichnet, dass** die Partikel in unterschiedlichen Kombinationen in Clustern angeordnet und innerhalb solcher Cluster elektrisch leitend miteinander verbunden sind, und dass die Cluster inselartig beabstandet zueinander und elektrisch isoliert voneinander auf dem Substrat angeordnet sind.

2. Antibakteriell ausgerüstetes Objekt nach Anspruch 1, **dadurch gekennzeichnet, dass** die durchschnittliche Clustergrösse kleiner ist als 100nm.

3. Antibakteriell ausgerüstetes Objekt nach einem der Ansprüche 1 oder 2, **dadurch gekennzeichnet, dass** das oder die weiteren Metalle aus einer Gruppe ausgewählt sind, die Silber, Kupfer, Gold, Eisen und Nickel umfasst.

4. Antibakteriell ausgerüstetes Objekt nach einem der Ansprüche 1 bis 3, wobei eines der weiteren Metalle Silber ist, **dadurch gekennzeichnet, dass** im beschichteten Oberflächenbereich des Substrats die pro m2 Oberfläche beschichtete Masse der Silberpartikel im Bereich von 50mg bis 100mg liegt.

5. Antibakteriell ausgerüstetes Objekt nach einem der Ansprüche 1 bis 4, **dadurch gekennzeichnet, dass** das Substrat mit Titan, Silber und Kupfer beschichtet ist, und dass das Verhältnis der Partikelzahlen von Kupfer:Silber im Bereich von 1:2 bis 1:6 liegt.

6. Antibakteriell ausgerüstetes Objekt nach einem der Ansprüche 1 bis 4, **dadurch gekennzeichnet, dass** das Substrat mit Titan, Silber, Kupfer und Gold beschichtet ist, dass das Verhältnis der Partikelzahlen von Kupfer:Silber im Bereich von 1:2 bis 1:4 liegt, und dass das Verhältnis der Partikelzahlen von Kupfer:Gold im Bereich von 2:1 bis 8:1 liegt.

7. Antibakteriell ausgerüstetes Objekt nach einem der Ansprüche 1 bis 6, **dadurch gekennzeichnet, dass** das Substrat ein textiles oder nicht textiles Flächengebilde (3) mit einer porösen Faserstruktur ist.

8. Antibakteriell ausgerüstetes Objekt nach einem der Ansprüche 1 bis 7, **dadurch gekennzeichnet, dass** dieses Objekt eine Filterkartusche, ein Luftfilter, eine Schutzmaske, ein Wundverband, ein Kleidungsstück, eine Schuheinlage, ein Reinigungstuch oder eine antiseptische Unterlage ist, und dass mindestens eine Lage des Substrats an der Oberfläche dieses Objekts angeordnet oder in das Objekt eingebettet ist.

9. Antibakteriell ausgerüstetes Objekt nach Anspruch 8, wobei dieses Objekt eine Filterkartusche (21) ist, **dadurch gekennzeichnet, dass** diese Filterkartusche (21) ein zylindrisches inneres Filterelement (27) und koaxial dazu eine zylindrisches äusseres Filterelement (29) umfasst, die gemeinsam einen Aufnahmeraum (30) für eine Wirksubstanz begrenzen, und dass jedes der Filterelemente (27, 29) eine oder mehrere Lagen des beschichteten Substrats umfasst.

10. Verfahren zur Herstellung eines antibakteriell ausgerüsteten Objekts, wobei dieses Objekt mindestens ein elektrisch nichtleitendes Substrat umfasst, **dadurch gekennzeichnet, dass** mindestens ein Abschnitt der Oberfläche des Substrats durch sequentielles Sputtern von Partikeln von Titan und einem oder mehreren weiteren Metallen in einer Sputteranlage beschichtet wird, wobei die gesputterten Partikel in unterschiedlichen Kombinationen in Clustern auf dem jeweiligen Oberflächenabschnitt des Substrats abgeschieden werden und innerhalb dieser Cluster elektrisch leitend miteinander verbunden sind, und wobei die Cluster inselartig beabstandet zueinander und elektrisch isoliert voneinander auf dem Substrat angeordnet werden.
